Europäisches Patentamt

European Patent Office

Office européen des brevets

(19)

(11) Veröffentlichungsnummer: **0 127 794**
**A2**

(12) # EUROPÄISCHE PATENTANMELDUNG

(21) Anmeldenummer: 84105229.3

(22) Anmeldetag: 09.05.84

(51) Int. Cl.³: **H 05 K 3/42**

(30) Priorität: 03.06.83 DE 3320183

(43) Veröffentlichungstag der Anmeldung:
12.12.84 Patentblatt 84/50

(84) Benannte Vertragsstaaten:
CH DE FR GB IT LI NL

(71) Anmelder: ANT Nachrichtentechnik GmbH
Gerberstrasse 33
D-7150 Backnang(DE)

(72) Erfinder: Seeger, Klaus, Dipl.-Ing.
Murrhardter Strasse 5
D-7150 Backnang(DE)

(74) Vertreter: Schickle, Gerhard, Dipl.-Ing.
ANT Nachrichtentechnik GmbH Patent- und
Lizenzabteilung Gerberstrasse 33
D-7150 Backnang(DE)

(54) Verfahren zum Herstellen gedruckter Schaltungen.

(57) Eine Verkürzung des Herstellungsverfahrens einer gedruckten Schaltung besteht darin, daß der als Ätzresist dienende Lack nach dem Ätzvorgang nicht von den Leiterbahnen entfernt wird, sondern auch beim späteren Lötvorgang als Lötstopplack ausgenutzt wird.

FIG.4

1

Verfahren zum Herstellen gedruckter Schaltungen

Die vorliegende Erfindung betrifft ein Verfahren zum Herstellen gedruckter Schaltungen, wobei ein kupferkaschiertes Basismaterial mit Kontaktstellen und einer Leiterstruktur versehen wird, die durch Belichten und Entwickeln eines auf das kupferkaschierte Basismaterial aufgebrachten, als Ätzresist dienenden, photosensitiven Lacks und durch Ätzen der Kupferkaschierung gebildet wird.

Ein derartiges Verfahren ist aus der DE-OS 29 32 536 bekannt. Gemäß diesem bekannten Verfahren wird nach dem Ätzen der Leiterstruktur der als Ätzresist wirkende photosensitive Lack von den Leiterbahnen entfernt. Im allgemeinen ist es erforderlich, die mit der Leiterstruktur und den Kontaktstellen versehene Leiterplatte vor dem Lötprozess mit einem Material zu überziehen, welches verhindert, daß sich außer an den Kontaktstellen auf den Leiterbahnen Lot niederschlägt. Ein solches Material, ein sogenannter Lötstopplack, wird üblicherweise, wie auch in der DE-OS 29 32 536 beschrieben, in einem gesonderten Verfahrensschritt nach der Beseitigung des Ätzresists auf die Leiterplatte aufgebracht.

Der Erfindung liegt nun die Aufgabe zugrunde, ein Verfahren zum Herstellen gedruckter Schaltungen gemäß der eingangs genannten Art anzugeben, das gegenüber den herkömmlichen Verfahren mit weniger Verfahrensschritten und auch mit weniger Beschichtungsmaterial auskommt.

Erfindungsgemäß wird diese Aufgabe dadurch gelöst, daß der als Ätzresist dienende Lack auch als Lötstopplack ausgenutzt wird, und zu diesem Zweck der Lack nach dem Galvanisieren der Kontaktstellen und dem Ätzen der Leiterstruktur auf den Leiterbahnen haften gelassen wird.

2

Zweckmäßige Weiterbildungen des erfindungsgemäßen Verfahrens
gehen aus den Unteransprüchen hervor.

Dadurch, daß nach der Erfindung der als Ätzresist dienende
photosensitive Lack auch als Lötstopplack ausgenutzt wird,
entfallen mehrere Verfahrensschritte, wie das Entfernen (strippen) des Ätzresists, das Aufbringen des Lötstopplacks auf die
Leiterplatte und in der Regel phototechnische Maßnahmen, um
die Kontaktstellen vom Lötstopplack freizuhalten. Außerdem
bringt die Erfindung eine Ersparnis an Beschichtungsmaterial,
nämlich des Lötstopplacks, mit sich.

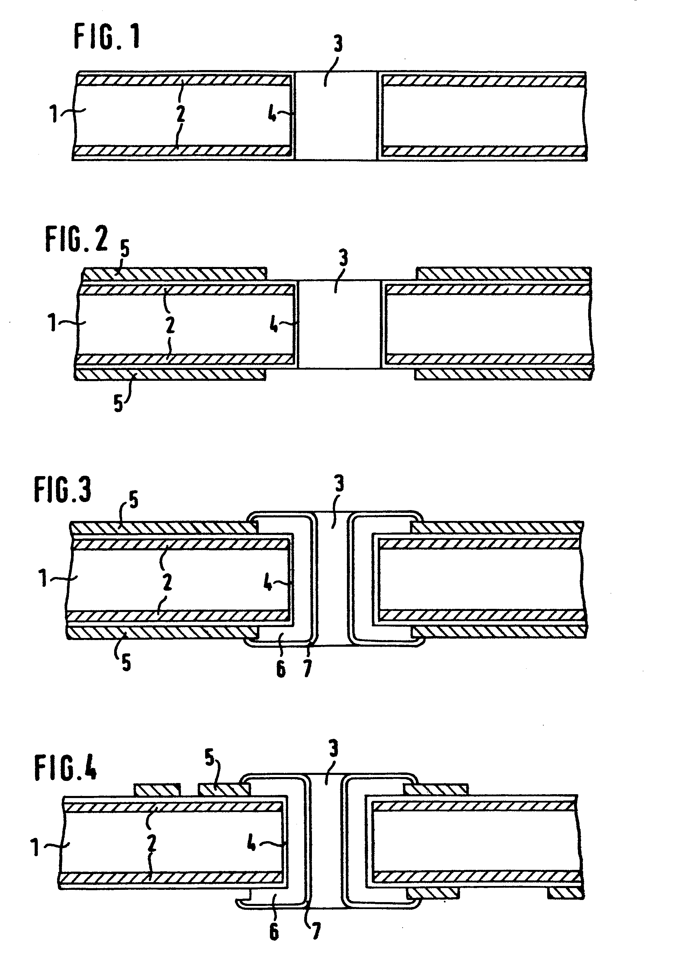

Anhand eines in der Zeichnung dargestellten Ausführungsbeispiels wird nun die Erfindung näher erläutert. Die Fig. 1 bis
7 verdeutlichen dabei die einzelnen Schritte des Verfahrens
zum Herstellen einer gedruckten Schaltung.

In der Fig. 1 ist ein beidseitig mit einer Kupferkaschierung
2 versehenes Basismaterial 1 für eine Leiterplatte dargestellt. Der gezeigte Ausschnitt des Basismaterials 1 besitzt
eine Bohrung 3. Durch diese Bohrung soll das Basismaterial
durchkontaktiert werden. Zu diesem Zweck werden in einem ersten Verfahrensschritt die Ober- und Unterseite des Basismaterials und die Innenwand der Bohrung mit einer durchgehenden dünnen Vorkupferschicht 4 überzogen.

Nachdem die Vorverkupferung beendet ist, wird beispielsweise
in einem Siebdruckverfahren auf die Vorkupferschicht 4 auf
beiden Seiten des Basismaterials ein photosensitiver Lack 5
aufgebracht (vgl. Fig. 2). Bei dem hier vorgestellten Ausführungsbeispiel wird ein negativ arbeitender photosensitiver Lack verwendet. Alle selektiv zu galvanisierenden Kontaktstellen, z.B. der Kontaktbereich um die in der Zeichnung
dargestellte Bohrung 3 herum, sind beim Beschichten mit dem
Lack auszusparen. Der photosensitive Lack 5 wird nun mit
dem Bild der Leiterstruktur belichtet.

3

Im Anschluß daran werden auf die vom Lack ausgesparten Kontaktstellen eine Kupferschicht 6 und darüber eine Zinn- bzw. Bleizinnschicht 7 aufgalvanisiert. Die Fig. 3 zeigt die beiden die Bohrungsinnenwand und den unmittelbaren Bereich um die Bohrung überdeckenden Metallschichten 6 und 7.

Nachdem der Schichtaufbau der Durchkontaktierung fertiggestellt ist, wird jetzt das Bild der Leiterstruktur in dem bereits belichteten photosensitiven Lack 5 entwickelt. Als Folge dieses Photoprozesses verbleibt der Lack 5 nur an den Stellen, wo die Leiterbahnen verlaufen sollen. Der Fig. 4 ist eine Leiterplatte in diesem Verfahrensstand zu entnehmen.

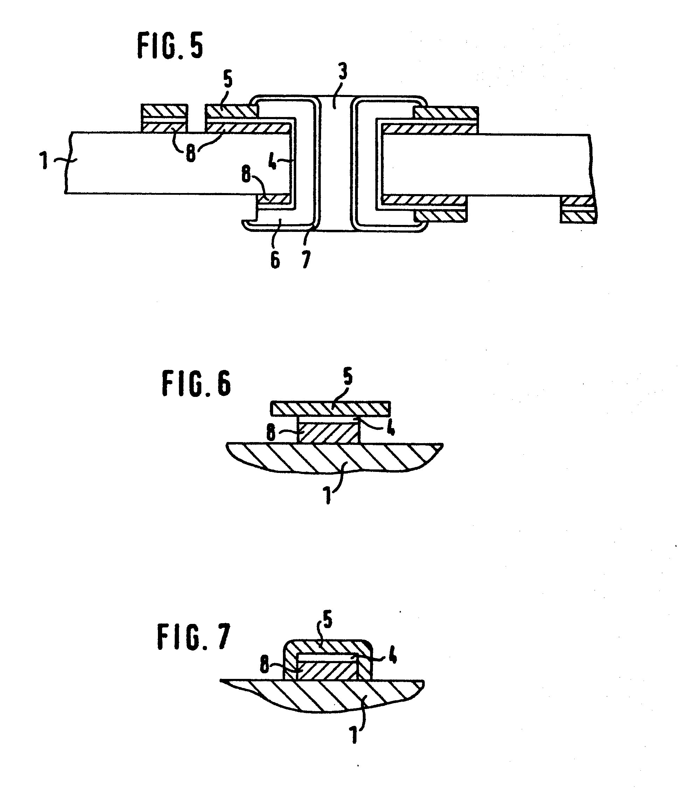

Da der photosensitive Lack 5 als Ätzresist wirkt, werden in einem nachfolgenden Ätzvorgang nur die nicht vom Lack überzogenen Bereiche der Kupferschichten 2, 4 auf dem Basismaterial 1 weggeätzt. Die Fig. 5 zeigt die nach dem Ätzen verbleibenden vom Lack 5 überdeckten Leiterbahnen 8.

Im Gegensatz zu hergebrachten Leiterplattenherstellungsverfahren wird der als Ätzresist wirkende photosensitive Lack 5 jetzt nicht von den Leiterbahnen entfernt, sondern der Lack verbleibt auf den Leiterbahnen 8 und wird beim späteren Lötprozess in der Eigenschaft als Lötstopplack ausgenutzt. Wie bereits eingangs erwähnt, spart man durch diese Maßnahme neben einer ganzen Reihe von Verfahrensschritten auch Lackmaterialien ein.

Die Ätzmittel greifen zu einem geringen Teil auch die vom Lack 5 abgedeckten Kupferschichten an. Der in Fig. 6 dargestellte Querschnitt durch eine Leiterbahn 8 zeigt, daß durch das Ätzen von den Leiterbahnflanken unterhalb der Lackschicht 5 Kupfermaterial abgetragen worden ist. Dadurch entstehen seitlich der Leiterbahn 8 Überhänge der Lackschicht 5. Vorteilhafterweise können diese Lacküberhänge

0127794

zum Schutz der Leiterbahnflanken ausgenutzt werden. Dazu
wird der Lack durch Erwärmen aufgeweicht. Die Folge davon
ist, daß die Lacküberhänge entsprechend der Fig. 7 über die
Leiterbahnkanten herabsinken und sich auf die Flanken der
Leiterbahnen legen.

- - - - -

5

ANT Nachrichtentechnik GmbH
Gerberstr. 33
D-7150 Backnang

E7/Th/kön
BK 83/16

Patentansprüche

1. Verfahren zum Herstellen gedruckter Schaltungen, wobei
   ein kupferkaschiertes Basismaterial mit Kontaktstellen
   und einer Leiterstruktur versehen wird, die durch Belichten und Entwickeln eines auf das kupferkaschierte Basismaterial aufgebrachten, als Ätzresist dienenden, photosensitiven Lacks und durch Ätzen der Kupferkaschierung
   gebildet wird, dadurch gekennzeichnet, daß der als Ätzresist dienende Lack (5) auch als Lötstopplack ausgenutzt
   wird und zu diesem Zweck der Lack nach dem Galvanisieren
   der Kontaktstellen und dem Ätzen der Leiterstruktur auf
   den Leiterbahnen (8) haften gelassen wird.

2. Verfahren nach Anspruch 1, dadurch gekennzeichnet, daß
   ein negativ arbeitender photosensitiver Lack (5) verwendet wird.

3. Verfahren nach Anspruch 1, dadurch gekennzeichnet, daß
   ein positiv arbeitender photosensitiver Lack (5) verwendet wird.

4. Verfahren nach einem der vorhergehenden Ansprüche, dadurch gekennzeichnet, daß der photosensitive Lack (5) im Siebdruckverfahren auf das kupferkaschierte Basismaterial (1) aufgebracht wird.

5. Verfahren nach einem der vorhergehenden Ansprüche, dadurch gekennzeichnet, daß nach dem Ätzen der Leiterstruktur der photosensitive Lack (5) mit Wärme behandelt wird, so daß die nach dem Ätzvorgang verbleibenden Lacküberhänge auf den Leiterbahnen (8) aufweichen und sich über die seitlichen Flanken der Leiterbahnen legen.

0127794

FIG.1

FIG.2

FIG.3

FIG.4

BK 83/16

0127794

FIG. 5

FIG. 6

FIG. 7